(19) Europäisches Patentamt
European Patent Office
Office européen des brevets

(11) Veröffentlichungsnummer: **0 072 918**
**B1**

(12) # EUROPÄISCHE PATENTSCHRIFT

(45) Veröffentlichungstag der Patentschrift: **17.12.86**

(21) Anmeldenummer: **82106391.4**

(22) Anmeldetag: **16.07.82**

(51) Int. Cl.⁴: **G 03 C 1/70**, G 03 C 1/68, G 03 F 7/10, G 03 F 7/26, C 08 G 18/66

(54) **Photopolymerisierbares Aufzeichnungsmaterial und Verfahren zur Herstellung von Reliefformen mittels dieses Aufzeichnungsmaterials.**

(30) Priorität: **11.08.81 DE 3131766**

(43) Veröffentlichungstag der Anmeldung: **02.03.83 Patentblatt 83/9**

(45) Bekanntmachung des Hinweises auf die Patenterteilung: **17.12.86 Patentblatt 86/51**

(84) Benannte Vertragsstaaten: **BE CH DE FR GB IT LI NL**

(56) Entgegenhaltungen:
**DE-A-2 116 591**
**US-A-3 658 531**

(73) Patentinhaber: **BASF Aktiengesellschaft, Carl-Bosch- Strasse 38, D-6700 Ludwigshafen (DE)**

(72) Erfinder: **Schornick, Gunnar, Dr., Obergasse 48, D-6719 Hettenleidelheim (DE)**
Erfinder: **Jun, Mong- Jon, Dr., Maulbeerstueck 20, D-6720 Speyer (DE)**
Erfinder: **Sanner, Axel, Dr., Lorscher Ring 2C, D-6710 Frankenthal (DE)**
Erfinder: **Lehner, August, Wachenheimer Strasse 4, D-6701 Roedersheim- Gronau (DE)**
Erfinder: **Lenz, Werner, Dr., Heinrich- Baermann-Strasse 14, D-6702 Bad Duerkheim (DE)**
Erfinder: **Richter, Peter, Dr., Bensheimer Ring 24, D-6710 Frankenthal (DE)**
Erfinder: **Eckell, Albrecht, Dr., Paul- Klee- Strasse 2, D-6710 Frankenthal (DE)**

EP 0 072 918 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1986

**Beschreibung**

Die vorliegende Erfindung betrifft ein photopolymerisierbares Aufzeichnungsmaterial mit einer auf einem Schichtträger aufgebrachten, in alkoholischen Lösungsmitteln entwickelbaren, photopolymerisierbaren Schicht, bei dem die photopolymerisierbare Schicht neben einer photopolymerisierbaren, ethylenisch ungesättigten niedermolekularen Verbindung, einem Photopolymerisationsinitiator sowie gegebenenfalls sonstigen üblichen Zusatzstoffen als Bindemittel ein Polyurethan mit Doppelbindungen, die der Photopolymerisation zugänglich sind, enthält. Die Erfindung betrifft des weiteren Verfahren zur Herstellung von Reliefformen, wie z. B. Druckplatten und Photoresists, mittels dieses photopolymerisierbaren Aufzeichnungsmaterials.

Es ist bekannt, Reliefdruckplatten oder Photoresists auf photochemischem Wege herzustellen, indem man eine auf einem Schichtträger aufgebrachte photopolymerisierbare Schicht bildweise mittels einer Strahlungsquelle, insbesondere aktinischem Licht, belichtet und die belichtete Photoschicht durch Behandeln mit einem Lösungsmittel entwickelt, in welchem die unbelichteten, nicht aber die belichteten Bereiche der Photoschicht löslich oder zumindest dispergierbar sind. Die photopolymerisierbare Schicht dieser Aufzeichnungsmaterialien enthält dabei im allgemeinen niedermolekulare photopolymerisierbare Verbindungen, Photoinitiatoren sowie ein polymeres Bindemittel, welches auch der Photopolymerisation oder Photovernetzung zugänglich sein kann. Die Anforderungen, die an solche photopolymerisierbaren Aufzeichnungsmaterialien und insbesondere auch an das polymere Bindemittel der photopolymerisierbaren Schicht gestellt werden, sind aus der einschlägigen Literatur bekannt. Es ist dabei heutzutage erstrebenswert, photopolymerisierbare Aufzeichnungsmaterialien zu schaffen, die nicht nur hinreichende mechanische und drucktechnische Eigenschaften besitzen, sondern darüber entwickelbar sind.

Photopolymerisierbare Aufzeichnungsmaterialen, die als Bindemittel in der photopolymerisierbaren Schicht ein Polyurethan enthalten, haben sich in mancher Hinsicht, insbesondere für den Druck mit Ölfarben als vorteilhaft erwiesen. So sind bereits vielfach für die Herstellung von Druckplatten geeignete photopolymerisierbare Gemische beschrieben, die neben einem Photoinitiator und gegebenenfalls anderen photopolymerisierbaren Verbindungen ein Polyurethan oder ein Polyurethan-Präpolymerisat mit Acrylatdoppelbindungen am Ende der Polyurethankette enthalten (vgl. z. B. DE–A–21 15 373, DE–A–24 27 494, DE–A–26 07 257, US–A–4 078 015, DE–A–26 41 189, DE–A–29 17 748). Bei Einsatz von bestimmten Polyetherurethanen mit endständigen Acrylatdoppelbindungen können so auch photopolymerisierbare Gemische erhalten werden, die mit Wasser oder wäßrig-alkalischen Medien entwickelbar sind (vgl. DE–A–21 15 373, DE–A–26 07 259, DE–A–29 17 748). Während in der DE–A–26 41 189 und DE–A–29 17 748 der Einsatz von niedermolekularen flüssigen Polyetherurethanen mit endständigen Acrylatdoppelbindungen beschrieben wird, sollen gemäß der DE–A–21 15 373, DE–A–24 27 494 oder US–A–4 078 015 niedermolekulare Polyurethane mit endständigen Acrylat-Doppelbindungen eingesetzt werden die bei Raumtemperatur zwar fest und trocken sind, bei erhöhter Temperatur jedoch niedrig-viskose Flüssigkeiten bilden.

Diese bekannten photopolymerisierbaren Gemische auf Basis von Polyurethanen mit endständigen Acrylatdoppelbindungen haben jedoch den Nachteil, daß die Polyurethane zur Erzielung des für die Härtung durch Photopolymerisation notwendigen hohen Doppelbindungsanteils im photopolymerisierbaren Gemisch recht niedermolekular sind und die photopolymerisierbaren Gemische daher nicht allen gewünschten mechanischen Anforderungen genügen.

Aus der US–A–2 948 611, der US–A–3 658 531 und der DE–A–23 00 371 ist es bekannt, für die Herstellung von flexiblen Druckplatten photopolymerisierbare Materialien einzusetzen, die als Basiskomponente Polyurethan-Elastomere mit seitenständigen Allyl- oder Vinyl-Gruppen enthalten. Im Vergleich zu den niedermolekularen Polyurethanen mit endständigen Acrylat-Doppelbindungen zeichnen sich die Polyurethane mit seitenständigen Vinylgruppen dadurch aus, daß die Anzahl der polymerisierbaren ungesättigten Gruppen im Polyurethan-Molekül bei gegebenem Molekulargewicht variiert werden kann, wodurch es möglich wird, höhermolekulare Produkte zum Einsatz zu bringen und dennoch eine hinreichend hohe Anzahl von Doppelbindungen für die Photopolymerisation zu haben. Ein Nachteil der in der US–A–2 948 611, der US–A–3 658 531 und DE–A–23 00 371 beschriebenen Verfahren für die Herstellung von flexiblen Druckplatten liegt darin, daß diese Platten nach dem Belichten nur mit Lösungsmitteln oder Lösungsmittel-Gemischen, z. B. Methylethylketon, Dimethylformamid, Dioxan oder Tetrahydrofuran, ausgewaschen und entwickelt werden können, die sehr wenig umwelt- und arbeitsfreundlich sind. Ferner lassen die Belichtungseigenschaften und vielfach auch die mechanischen und anwendungstechnischen Eigenschaften dieser Platten zu wünschen übrig.

Aufgabe der vorliegenden Erfindung ist es, ein photopolymerisierbares Aufzeichnungsmaterial mit einer in alkoholischen Entwicklerflüssigkeiten löslichen oder zumindest dispergierbaren photopolymerisierbaren Schicht auf Polyurethan-Basis aufzuzeigen, das leicht herstellbar, bereits vor der Belichtung leicht handhabbar und verarbeitbar ist, möglichst geringe Neigung zum Kaltfluß und insbesondere zum Verspröden besitzt. Das Aufzeichnungsmaterial soll sich zur Herstellung von Reliefdruckplatten, insbesondere weichelastomeren Reliefdruckplatten eignen, dementsprechend gute Belichtungseigenschaften und hohes Auflösungsvermögen sowie nach der Belichtung und Entwicklung gute Druckeigenschaften bei gleichzeitig hoher Wiederverwendbarkeit besitzen.

In der älteren, nicht vorveröffentlichten europäischen Patentanmeldung 54 150 vom 23.10.1981 werden hierzu bereits photopolymerisierbare Aufzeichnungsmaterialien beschrieben, die als Bindemittel in der photopolymerisierbaren Schicht ein hochmolekulares, thermoplastisches Polyurethan mit seitenständigen photopolymerisierbaren Doppelbindungen und quaternären und/oder quaternisierbaren Stickstoffatomen ent-

halten. Diese photopolymerisierbaren Aufzeichnungsmaterialien sind mit Wasser oder wäßrigen Lösungen entwickelbar.

Es wurde nun gefunden, daß man zu alkohol-entwickelbaren Aufzeichnungsmaterialien mit sehr guten mechanischen und anwendungstechnischen Eigenschaften auch dann kommt, wenn die photopolymerisierbare Schicht als Bindemittel ein nachfolgend beschriebenes spezielles Polyurethan ohne quaternäre und/oder quaternisierbare Stickstoffatome enthält.

Gegenstand der vorliegenden Erfindung ist demzufolge ein photopolymerisierbares Aufzeichnungsmaterial mit einem Schichtträger A, einer damit direkt oder indirekt haftfest verbundenen, in alkoholischer Lösung löslichen oder zumindest dispergierbaren photopolymerisierbaren Schicht B sowie gegebenenfalls einer Deckschicht und/oder Deckfolie C, bei dem die photopolymerisierbare Schicht B

1. als polymeres Bindemittel ein in einem Lösungsmittel lösliches Polyurethan aus einem Diisocyanat, einem Polyetherdiol und einer weiteren difunktionellen Verbindung mit seitenständigen photopolymerisierbaren Doppelbindungen,
2. mindestens eine photopolymerisierbare, ethylenisch ungesättigte niedermolekulare Verbindung,
3. einen Photopolymerisationsinitiator sowie
4. gegebenenfalls sonstige übliche Zusatzstoffe enthält, welches dadurch gekennzeichnet ist, daß in der photopolymerisierbaren Schicht B als Bindemittel (Komponente B1) ein lineares, bei Raumtemperatur festes, hochmolekulares, thermoplastisches Polyurethan enthalten ist, das keine quaternären und/oder quaternisierbaren Stickstoff-Atome eingebaut enthält und erhalten worden ist durch Umsetzung einer Reaktionsmischung von

a) 10 bis 40 Gew.% eines Diisocyanats

b) 30 bis 85 Gew.% eines Polydiols bestehend zu 50 bis 100 Gew.%, bezogen auf die Polydiol-Komponente b), aus mindestens einem Polyetherdiol mit einem Molekulargewicht von 250 bis 4000 aus der Gruppe der Polyethylenglykole, Polypropylenglykole und Ethylenglykol-Propylenglykol-Mischpolykondensationsprodukte sowie 0 bis 50 Gew.%, bezogen auf die Polydiol-Komponente b), mindestens eines weiteren verträglichen Polydiols,

c) 0,1 bis 20 Gew.% einer kettenverlängernden, im Sinne der Isocyanatchemie bifunktionell reaktionsfähigen Verbindung mit seitenständigen aktivierten photopolymerisierbaren Doppelbindungen sowie d) 0 bis 20 Gew.% eines weiteren niedermolekularen Kettenverlängerers,

wobei die angegebenen Gew.% für die Komponenten der Reaktionsmischung jeweils auf die Summe der Komponenten a) bis d) bezogen sind und das NCO/OH, NH-Molverhältnis in der Reaktionsmischung 0,8 bis 1,3 beträgt.

Gegenstand der Erfindung sind weiterhin spezielle Ausgestaltungsformen dieses photopolymerisierbaren Aufzeichnungsmateriales gemäß der nachfolgenden detaillierten Beschreibung. Gegenstand der Erfindung sind ferner Verfahren zur Herstellung von Reliefformen, wie z. B. von ölfesten Reliefdruckplatten, insbesondere ölfesten weichelastomeren Reliefdruckplatten, oder von Photoresists, mittels des photopolymerisierbaren Aufzeichnungsmaterials.

Es war überraschend, daß bei Einsatz der erfindungsgemäßen Polyurethane als Bindemittel photopolymerisierbare Aufzeichnungsmateralien mit insgesamt sehr guten Eigenschaften und einer Reihe besonderer Vorteile erhalten werden, die für die Herstellung von Reliefdruckplatten oder Photoresists geeignet sind. So besitzen die Polyurethane bereits im Grundzustand eine hohe Reißkraft, gute Dehnung- und Biegeeigenschaften sowie Elastizität, so daß die Aufzeichnungsmaterialien bereits vor der Belichtung ein hohes mechanisches Niveau aufweisen und sich die von der Anwendung her geforderten Eigenschaften der belichteten Materialien, wie z. B. Elastizität und Härte, in dem gewünschten Rahmen einstellen lassen, ohne daß hierfür andere Nachteile, wie beispielsweise Verspröden oder geringe Alterungsbeständigkeit, in Kauf genommen werden müssen. Die photopolymerisierbaren Aufzeichnungsmaterialien lassen sich wegen des sehr guten Gelierverhaltens der photopolymerisierbaren Schicht bequem und vorteilhaft durch Gießen aus Lösungen herstellen. Sie besitzen hervorragende Belichtungseigenschaften und die daraus hergestellten Reliefdruckplatten zeichnen sich durch gute mechanische und anwendungstechnische Eigenschaften aus.

Die in den erfindungsgemäßen photopolymerisierbaren Aufzeichnungsmaterialien als Komponente B1 einzusetzenden Polyurethane sind im wesentlichen linear und bei Raumtemperatur fest und im allgemeinen nicht klebrig. Sie sollen dabei hochmolekular sein und weisen im allgemeinen K-Werte (nach Fikentscher, Cellulosechemie 13, 58 (1932)) zwischen 25 und 75 auf. Vorzugsweise liegen die K-Werte im Bereich von etwa 35 bis 65. Die in den erfindungsgemäß einzusetzenden Polyurethanen (B1) enthaltenen photopolymerisierbaren Doppelbindungen sind seitenständig zur Polyurethan-Hauptkette eingebaut, d.h. in einer Seitengruppe an die Polyurethan-Hauptkette gebunden. Es handelt sich hierbei um aktivierte Kohlenstoff-Kohlenstoff-Doppelbindungen, die in den Seitengruppen vorteilhafterweise endständig stehen, insbesondere um Acryloyl- und/oder Methacryloyl-Gruppen. Der Gehalt an den seitenständigen, photopolymerisierbaren Doppelbindungen in dem Polyurethan (B1) beträgt 0,01 bis 2,5 Gew.%, bezogen auf das Gewicht des Polyurethans. Der Anteil der seitenständigen photopolymerisierbaren Doppelbindungen im Polyurethan (B1) richtet sich dabei sowohl nach der Reaktivität der Doppelbindungen als auch nach dem angestrebten Vernetzungsgrad nach der Belichtung und damit zusammenhängend nach dem gewünschten Eigenschaftsbild des Aufzeichnungsmaterials. Es hat sich als vorteilhaft herausgestellt, wenn das Polyurethan (B1) mindenstens 0,05 Gew.% an eingebauten seitenständigen, photopolymerisierberen Doppelbindungen, bezogen auf das Gewicht des Polyurethans, enthält. Je nach Art und Verwendungszweck des photopolymerisierbaren Aufzeichnungsmaterials ist es

günstig, wenn der Gehalt an eingebauten seitenständigen, photopolymerisierbaren Doppelbindungen im Polyurethan (B1) nicht über 2 Gew.%, bezogen auf das Gewicht des Polyurethans, liegt. Das Gewicht der Kohlenstoff-Kohlenstoff-Doppelbindung wird dabei mit 24 gerechnet.

Die in der photopolymerisierbaren Schicht B erfindungsgemäß als Bindemittel einzusetzenden Polyurethane (B1) können in an sich üblicher Weise durch Umsetzung von Diisocyanaten mit den entsprechenden Polydiolen, geeigneten olefinisch ungesättigten Verbindungen mit zwei im Sinne der Isocyanatchemie, reaktionsfähigen Wasserstoffatomen sowie gegebenenfalls weiteren, für die Herstellung von Polyurethanen üblichen niedermolekularen Diolen, Diaminen oder Aminoalkoholen als Kettenverlängerer hergestellt werden. Zu den Aufbaukomponenten der erfindungsgemäß einzusetzenden Polyurethane (B1) ist im einzelnen folgendes auszuführen:

Als Diisocyanate, die allein oder im Gemisch miteinander eingesetzt werden können, eignen sich die üblichen, aus der Polyurethanchemie bekannten Verbindungen. Es kommen dabei im Prinzip beliebige aliphatische, cycloaliphatische, araliphatische, aromatische und heterocyclische Diisocyanate in Betracht. Beispielhaft seien genannt 4,4'-Diphenylmethandiisocyanat, Dicyclohexylmethandiisocyanat, 1,5-Naphthylendiisocyanat, 2,4- und 2,6-Toluylendiisocyanat, Hexamethylendiisocyanat, Isophorondiisocyanat und Trimethylhexamethylendiisocyanat. Weitere geeignete Diisocyanate sind u.a. 4,4'-Dibenzyldiisocyanat, 1,3- und 1,4-Phenyldiisocyanat, Cyclohexan-1,4-diisocyanat, Xylylendiisocyan, halogenierte Diisocyanate, wie z. B. 4-Chlor-1,3-Phenyldiisocyanat, sowie die Hydrierungsprodukte von aromatischen Diisocyanatverbindungen, wie z. B. 1,5-Tetrahydronaphthylendiisocyanat. Bevorzugt werden aliphatische oder cycloaliphatische Diisocyanate verwendet. Die Diisocyanate werden bei der Herstellung der erfindungsgemäß zu verwendenden Polyurethane (B1) in solchen Mengen eingesetzt, daß ihr Gehalt im Polyurethan zwischen 10 und 40 Gew.%, insbesondere im Bereich von etwa 15 bis 30 Gew.%, bezogen auf das Polyurethan, liegt.

Als Polydiole für den Aufbau der erfindungsgemäß einzusetzenden Polyurethane (B1) kommen die im wesentlichen linearen, bekannten Polyetherdiole aus der Gruppe der Polyethylenglykole, Polypropylenglykole und Ethylenglykol-/Propylenglykol-Mischkondensationsprodukte zum Einsatz, wobei in den Mischpolykondensationsprodukten der Propylenoxid-Anteil vorzugsweise 10 bis 90 Gew.%, bezogen auf das Mischpolykondensat, beträgt. Das Molekulargewicht dieser Polyetherdiole liegt im allgemeinen zwischen 250 und 4000, vorzugsweise zwischen etwa 500 und 2000. Zur Herstellung der erfindungsgemäß einzusetzenden Polyurethane (B1) können die genannten speziellen Polyetherdiole vorzugsweise alleine oder in Mischung miteinander, aber auch in Mischung mit anderen verträglichen Polydiolen eingesetzt werden, wobei in den letztgenannten Mischungen der Anteil der weiteren Polydiole 50 Gew.%, bezogen auf die Mischung der Polydiole, nicht überschreiten sollte.

Als weitere Polydiole, die gegebenenfalls in Mischung mit den genannten speziellen Polyetherdiolen verwendet werden können, eignen sich die im wesentlichen linearen bekannten Polyesterdiole, andere Polyetherdiole, Polylacton- sowie Polycarbonatdiole. Außer den endständigen Hydroxylgruppen können die Polydiole gegebenenfalls in geringem Umfang auch noch Carboxyl-, Amino- oder Mercaptogruppen enthalten. Geeignete Polyesterdiole sind insbesondere die gesättigten Polyesterdiole, wie z. B. Veresterungsprodukte von Dicarbonsäuren, insbesondere Adipinsäure, mit $C_2$- bis $C_{10}$-Alkandiolen oder Oxalkandiolen mit 2 bis 6 Kohlenstoffatomen. Beispielhaft seien als Polyesterdiole genannt Adipate mit Glykol (Molekylargewicht etwa 2000), mit Diethylenglykol (Molekulargewicht ca. 2000), mit Butandiol-1,4 (Molekulargewicht 940), mit Hexandiol-1,6 (Molekulargewicht 1000), mit einem Hexandiol-1,6/Butandiol-1,4-Gemisch im Verhältnis 1 : 1 (Molekulargewicht 1000 bzw. 2000) und 2,2-Dimethylpropandiol-1,3 (Molekulargewicht 1000). Geeignete Polycarbonatdiole sind z. B. Hexandiolpolycarbonate. Für die Polylactondiole seien stellvertretend die Polycaprolactondiole (Molekulargewicht 830 und 2000) genannt. Als weitere Polyetherdiole kommen beispielsweise die Polymerisationsprodukte des Tetrahydrofurans oder Butylenoxids in Betracht.

Die Polydiole werden bei der Herstellung der erfindungsgemäß einzusetzenden Polyurethane (B1) in solchen Mengen verwendet, daß ihr Anteil im Polyurethan von etwa 30 bis 85 Gew.%, insbesondere von etwa 50 bis 80 Gew.%, bezogen auf das Polyurethan, beträgt.

Die seitenständigen, photopolymerisierbaren Doppelbindungen werden in das erfindungsgemäß einzusetzende Polyurethan (B1) eingeführt, indem man bei dessen Herstellung kettenverlängernde Verbindungen mitverwendet, die seitenständige aktivierte Doppelbindungen aufweisen. Als geeignete kettenverlängernde Verbindungen mit aktivierten Doppelbindungen kommen z. B. ungesättigte Carbonsäureesterdiole in Betracht. Hierbei kann es sich beispielsweise um Reaktionsprodukte von Dicarbonsäuren mit polymerisierbaren, olefinisch ungesättigten Glycidylverbindungen handeln. Solche Verbindungen sind z. B. in der DE–A–21 64 386 beschrieben. Es kommen jedoch in gleicher Weise auch die Reaktionsprodukte von Epoxidverbindungen mit polymerisierbaren, olefinisch ungesättigten Carbonsäuren in Betracht. Als besonders vorteilhaft haben sich Reaktionsprodukte von Epoxiden mit α,β-ungesättigten Monocarbonsäuren, insbesondere Acryl- und/oder Methacrylsäure, erwiesen. Bei den Epoxiden kann es sich um OH-Gruppen tragende Monoepoxide, wie z. B. Glycidol, handeln; es können aber auch Epoxide mit zwei endständigen Epoxidgruppen sein. Insbesondere bevorzugt sind dabei die Reaktionsprodukte von Acryl- und/oder Methacrylsäure mit Diepoxiden entsprechend der allgemeinen Formel (I)

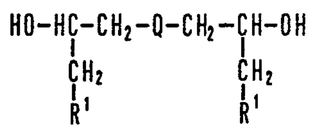 (I)

worin bedeuten:

$R^1$ eine $(CH_2{=}CR^2\text{-}CO\text{-}O)$-Gruppe mit $R^2$ = einem Wasserstoffatom oder einem Methyl-Rest,

Q -O-; $-O-(CH_2)_m-O$; $-O-(CH_2-CH_2-O-)_n$; $-O-(CHCH_3-CH_2-O-)$ mit m, n und p unabhängigen ganzen Zahlen von 1 bis 10, vorzugsweise von 1 bis 7; oder ein Rest der allgemeinen Formel (II)

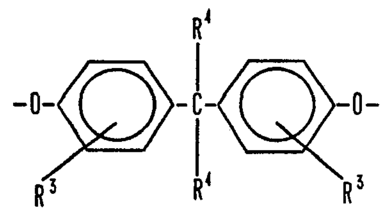 (II)

worin stehen

$R^3$ und

$R^4$ für ein Wasserstoffatom oder eine Alkyl-Gruppe mit 1 bis 10 Kohlenstoffatomen, z. B. die Methyl-, Ethyl-, Propyl-, Butyl- oder Hexyl-Gruppe.

Die Umsetzung zwischen den Epoxidverbindungen und den polymerisierbaren olefinisch ungesättigten Carbonsäuren ist eine ringöffnende Veresterung zwischen den Epoxidgruppen der Diepolyverbindungen und den Carboxylgruppen der Carbonsäuren, die etwa analog der DE–A– 21 64 386 in bekannter Weise ausgeführt werden kann (vgl. auch US–A–3 373 075 und US–A–2 824 851). Die vorgenannten Epoxidverbindungen und deren Umsetzungsprodukte können allein oder im Gemisch miteinander verwendet werden. Bevorzugt eignen sich für den Zweck der Erfindung Umsetzungsprodukte aus Bisphenol–A–Diglycidylether (z. B. ®Epikote 828 der Fa. Shell) oder 2,3-Epoxpropanol-1 (Glycidol) mit Acryl- und/oder Methacrylsäure.

Die ungesättigten Carbonsäureesterdiole, insbesondere die Reaktionsprodukte von Acryl- und/oder Methacrylsäure mit Epoxidverbindungen, haben ein Molekulargewicht zwischen 146 und 3000.

Als weitere Gruppe von kettenverlängernden Verbindungen mit seitenständigen aktivierten Doppelbindungen seien Bis-(meth)acrylamid-Derivate mit 2 gegenüber Isocyanat reaktionsfähigen Wasserstoffatomen genannt, wie sie etwa beispielsweise bei der Umsetzung von (Meth)acrylamid mit Dialdehyden entstehen.

Die kettenverlängernden Verbindungen mit den seitenständigen aktivierten Doppelbindungen sollten für die spätere Umsetzung mit den Diisocyanaten im wesentlichen bifunktionell sein. Ist die Funktionalität gegenüber Isocyanatgruppen größer als 2 erfolgt gegebenenfalls eine zu starke Verzweigung des Polyurethan-Moleküls bzw. besteht die Gefahr einer Vernetzung. Sie werden bei der Herstellung der Polyurethane (B1) im allgemeinen in Mengen von 0,1 bis 20 Gew.%, insbesondere von etwa 0,5 bis 15 Gew.%, bezogen auf die Reaktionsmischung, eingesetzt.

Neben den genannten Verbindungen können bei der Herstellung der erfindungsgemäß einzusetzenden Polyurethane (B1) weitere niedermolekulare Diole, Diamine oder Aminoalkohole mit Molekulargewichten zwischen 60 und 400 als Kettenverlängerungsmittel eingesetzt werden. Der Einsatz solcher zusätzlichen Kettenverlängerungsmittel hängt einerseits ab von den gewählten Ausgangsverbindungen und dem gewünschten Molekulargewicht, andererseits aber auch von den angestrebten Eigenschaften des Polyurethans und des Aufzeichnungsmaterials. So führen beispielsweise Harnstoff-Gruppen im Polyurethan, wie sie z. B. bei Einsatz von Diaminen oder Aminoalkoholen als Kettenverlängerer gebildet werden, zu härteren Produkten. Als Kettenverlängerer werden vorzugsweise niedermolekulare Diole, wie z. B. die üblichen gesättigten oder ungesättigten Glykole, wie Ethylenglykol und Kondensate des Ethylenglylols, Butandiol, Propandiol-1,2, Propandiol-1,3, Neopentylglykol, Hexandiol-1,6, Decandiol-1,10, Dioxethoxyhydrochinon, Butendiol, Dimethylolnorbonen oder Dioxethylolcyclohexen, in Mergen von 1 bis 20 Gew.%, insbesondere 1 bis 10 Gew.%, eingesetzt.

Die Herstellung der Polyurethane kann unter den aus der Literatur bekannten üblichen Bedingungen der Polyaddition in Masse oder in Lösung erfolgen. Die einzelnen Komponenten werden dabei im allgemeinen in einem solchen Verhältnis zueinander eingesetzt, daß des NCO/OH, NH-Molverhältnis etwa 0,8 bis 1,30, insbesondere etwa 0,9 bis 1,2, beträgt.

Zweckmäßigerweise erfolgt die Herstellung der Polyurethane in Lösung. Dabei kann jedes beliebige

Lösungsmittel eingesetzt werden, das mit der Polyurethanmasse und den Reaktionspartnern nicht in Reaktion tritt. Bevorzugte Lösungsmittel sind gegebenenfalls halogenierte Kohlenwasserstoffe, Ketone, Ether, Ester oder Nitrile, wie z. B. Aceton, Methylethylketon, Acetonitril, Ethylacetat, Methylenchlorid, Chloroform, Tetrachlorkohlenstoff, Dimethylformamid, Dimethylsulfoxid, Tetrahydrofuran, Dioxan oder t-Butanol. Selbstverständlich können auch Mischungen derartigen Lösungsmittel verwendet werden. Für die Herstellung der Polyurethane in Lösung bieten sich die bekannten und üblichen Ein- oder Mehrstufenverfahren an.

Die Polyaddition kann mit und ohne Katalysatoren durchgeführt werden. Geeignete Katalysatoren sind z. B. tertiäre Amine, wie etwa Triäthylendiamin; Metallsalze, wie z. B. Caliumacetat; oder organische Metallverbindungen, wie z. B. Dibutylzinndilaurat und Zinnoctoat. Diese Katalysatoren werden, insbesondere in Mengen von 0,001 bis 0,5 Gew.%, bezogen auf das Polymere zugesetzt.

Die photopolymerisierbare Schicht B der photopolymerisierbaren Aufzeichnungsmaterialien kann in der Komponente (B1) neben den erfindungsgemäß einzusetzenden, vorgehend beschriebenen Polyurethanen auch noch weitere übliche polymere Bindemittel, die mit den in Rede stehenden Polyurethanen verträglich sind, enthalten. Als solche weiteren Bindemittel, die neben den erfindungsgemäß einzusetzenden Polyurethanen in der photopolymerisierbaren Schicht B enthalten sein können, kommen beispielsweise andere Polyurethane und gegebenenfalls modifizierte Polyvinylalkohole bzw. Vinylalkoholpolymerisate in Betracht. Der Anteil der erfindungsgemäß einzusetzenden Polyurethane soll 60 bis 100 Gew.%, bezogen auf das gesamte Bindemittel (Komponente B1), betragen. Bevorzugt werden die erfindungsgemäß einzusetzenden Polyurethane als einziges Bindemittel in der photopolymerisierbaren Schicht B der Aufzeichnungsmaterialien eingesetzt.

Die photopolymerisierbare Schicht B der Aufzeichnungsmaterialien enthält neben dem polymeren Bindemittel (Komponente B1) als weitere Bestandteile mindestens eine photopolymerisierbare, ethylenisch ungesättigte niedermolekulare Verbindung ((Komponente B2), mindestens einen Photopolymerisationsinitiator (Komponente B3) sowie gegebenfall sonstige übliche Zusatzstoffe (Komponente B4).

Als photopolymerisierbare, ethylenisch ungesättigte niedermolekulare Verbindungen (Komponente B2) kommen die an sich bekannten Monomeren und/oder Oligomeren (mit einem Molekulargewicht bis zu 5000, vorzugsweise mit einem Molekulargewicht bis zu 3000) in Frage, die für photopolymerisierbare Aufzeichnungsmaterialien der in Rede stehenden Art üblich und gebräuchlich sind. Die photopolymerisierbaren, ethylenisch ungesättigten Verbindungen (Komponente B2) sollen dabei - für den Fachmann selbstverständig - mit dem polymeren Bindemittel (Komponente B1) verträglich sein und im allgemeinen einen Siedepunkt von über 100°C bei Atmosphärendruck aufweisen. Die photopolymerisierbaren, ethylenisch ungesättigten Verbindungen (Komponente B2) können monofunktionell oder mehrfunktionell sein, d.h. sie können eine oder mehrere der photoinitiierten Polymerisationsreaktion zugängliche C-C-Doppelbindungen besitzen. Die photopolymerisierbaren, ethylenisch ungesättigten Verbindungen (Komponente B2) können dabei alleine als auch in Mischung miteinander eingesetzt werden. Vorzugsweise werden mehrfunktionelle Verbindungen dieser Art in dem photopolymerisierbaren Aufzeichnungsmaterial eingesetzt; in bestimmten Anwendungsfällen sind als Komponente (B2) Kombinationen von mono- und mehrfunktionellen, insbesondere Kombinationen von mono- und bifunktionellen photopolymerisierbaren, ethylenisch ungesättigten Verbindungen von Vorteil. Die Art als auch die Menge der eingesetzten photopolymerisierbaren, ethylenisch ungesättigten Verbindungen (Komponente B2) richtet sich natürlich nach dem mitverwendeten polymeren Bindemittel (Komponente B1) und insbesondere nach Art und Anwendungszweck des photopolymerisierbaren Aufzeichnungsmaterials, d.h. nach dessen angestrebten Eigenschaftsbild. So sind beispielsweise für die Herstellung von Reliefdruckplatten im Hochdruck- und Akzidenz-Bereich mehrfunktionelle, schnell vernetzende photopolymerisierbare, ethylenisch ungesättigte Verbindungen als Komponente (B2) von Vorteil; für Aufzeichnungsmaterialien, die zur Herstellung von weichelastomeren Reliefdruckplatten verwendet werden sollen, sind als Komponente (B2) unter anderem Mischungen aus mono- und mehrfunktionellen photopolymerisierbaren Monomeren und/oder Oligomeren günstig.

Das Mengenverhältnis von polymerem Bindemittel (Komponente B1) zu den photopolymerisierbaren, ethylenisch ungesättigten niedermolekularen Verbindungen (Komponente B2) in der photopolymerisierbaren Schicht B ist in weitem Umfang variierbar. Es beträgt im allgemeinen etwa 95 bis 50 Gew.-% an polymerem Bindemittel (Komponente B1) zu 5 bis 50 Gew.-% an photopolymerisierbaren, ethylenisch ungesättigten Verbindungen (Komponente B2). Vorzugsweise, insbesondere im Anwendungsbereich für die Herstellung von weichelastomeren Reliefdruckplatten, liegt das Verhältnis der Komponenten (B1) und (B2) in der photopolymerisierbaren Schicht B bei etwa 90 bis 60 Gew.-% an polymerem Bindemittel (Komponente B1) zu 10 bis 40 Gew.-% an photopolymerisierbaren, ethylenisch ungesättigten Verbindungen (Komponente B2), wobei diese Angaben jeweils auf die Summe der Komponenten (B1) und (B2) gezogen sind. Werden als Komponente (B2) Mischungen aus monofunktionellen und mehrfunktionellen photopolymerisierbaren, ethylenisch ungesättigten Verbindungen eingesetzt, so liegt der Anteil der monofunktionellen photopolymerisierbaren, ethylenisch ungesättigten Verbindungen hierin im allgemeinen im Bereich von 5 bis 50 Gew.-%, insbesondere von 5 bis 30 Gew.-%, bezogen auf die Komponente (B2).

Geeignete photopolymerisierbare, ethylenisch ungesättigte niedermolekulare Verbindungen, die als Komponente (B2) in den erfindungsgemäßen photopolymerisierbaren Aufzeichnungsmaterialien eingesetzt werden können, sind unter anderem beispielsweise in den US-Patentschriften 2 760 863 und 3 060 203 beschrieben. Beispielsweise eignen sich Vinylether von Alkoholen, wie Octadecylvinylether oder Butandiol-1,4-divinylether. Vorteilhaft sind Derivate, z. B. Ester oder Amide, von ungesättigten Carbonsäuren, wie der Acryl- oder Methacrylsäure. Hierzu gehören unter anderem neben Acrylsäure und Methacrylsäure selber Acrylamid und

Methacrylamid, die N-Hydroxyalkyl(meth)acrylamide mit 1 bis 6 Kohlenstoff-Atomen in der Alkyl-Gruppe, wie z. B. N-Hydroxymethyl-(meth)-acrylamid oder N-Hydroxyethyl-(meth)-acrylamid; Derivate und Umsetzungsprodukte dieser (Meth)-Acrylamide sowie insbesondere die Ester der Acrylsäure und Methacrylsäure von Dialkoholen oder Polyalkoholen, wie z. B. die Di- bzw. Tri-(meth)-acrylate von Ethylenglykol, Diethylenglykol, Triethylenglykol, Polyethylenglykol mit einem Molekulargewicht bis etwa 500, 1,2-Propandiol, 1,3-Propandiol, Neopentylglykol(2,2-Dimethyl-propandiol), 1,4-Butandiol, 1,1,1-Trimethylolpropan, Glycerin oder Pentaerythrit; ferner die Monoacrylate und Monomethacrylate solcher Diole und Polyole, wie z. B. die Monoacrylate und Monomethacrylate des Ethylenglykols, des Di-, Tri- oder Tetraethylenglykols. Besonders günstig sind wegen ihrer Verträglichkeit mit den polymeren Bindemitteln (Komponente B1) sowie wegen ihrer elastizitätsverbessernden Eigenschaften insbesondere für den Flexodruck-Anwendungsbereich niedermolekulare, präpolymere Urethanacrylate, wie sie z. B. durch Umsetzung von Hydroxyalkyl-(meth)acrylaten (z. B. β-Hydroxyethyl-(meth)acrylat, β-Hydroxypropyl-(meth)acrylat), aliphatischen Diolen (z. B. der vorstehend genannten Art) und organischen Diisocyanaten (z. B. Hexamethylendiisocyanat oder Isophorondiisocyanat) hergestellt werden können. Solche niedermolekularen, präpolymeren Urethanacrylate, die vorzugsweise ein Molekulargewicht unter 5000, insbesondere zwischen 500 und 3000 besitzen, sind beispielsweise in der DE–A–16 44 797 beschrieben.

Als Photopolymerisationsinitiatoren (Komponente B3) kommen die bekannten und üblichen Verbindungen und Systeme für die Auslösung einer Photopolymerisationsreaktion bei Bestrahlung mit aktinischem Licht in Frage, wie sie hinreichend in der einschlägigen Fachliteratur beschrieben sind. Dabei werden solche Initiatoren bevorzugt, die unterhalb von 120°C, vorzugsweise underhalb von 185°C thermisch inaktiv sind. Sie sollten in der photopolymerisierbaren Schicht B in dem Maße dispergierbar sein, welches zur Auslösung der gewünschten Polymerisation oder Vernetzung unter dem Einfluß der aktinischen Strahlung notwendig ist.

Genannt seien als Photoinitiatoren z. B. Acyloine und deren Derivate, wie Benzoin, Benzoinalkylether, α-Methylolbenzoin und dessen Ether, α-Methylbenzoin; vicinale Diketone und deren Derivate, wie z. B. Diacetyl, Benzil, Benzilketale, wie Benzildimethylketal, Benzilmethylethylketal, Benzilmethylbenzylketal, Benzilmethylallylketal oder Benzilethylenglykol-Monoketal; unsubstituierte und substituierte Chinone, wie Anthrachinon, Benzanthrachinon; Benzophenon und 4,4'-Bis-(dimethylamino)-benzophenon; und insbesondere Acylphosphinoxid-Verbindungen des Typs, wie sie z. B. in der DE–A–29 09 992 beschrieben sind.

Die Photopolymerisationsinitiatoren können alleine oder im Gemisch miteinander verwendet werden. Die Photoinitiatoren werden dabei in für die Initiierung der Photopolymerisation wirksamen Mengen eingesetzt. Je nach Extinktionskoeffizient des Initiators, Schichtdicke des Aufzeichnungsmaterials etc. beträgt die Menge des eingesetzten Photopolymerisationsinitiators im allgemeinen 0,02 bis 5 Gew.%, vorzugsweise 0,1 bis 3 Gew.-%, bezogen auf die Summe aller Komponenten der photopolymerisierbaren Schicht B. Die Photopolymerisationsinitiatoren können auch in Verbindung mit anderen Coinitiatoren oder Aktivatoren verwendet werden. So können beispielsweise Initiatorsysteme aus Benzoinmethylether und Triphenylphosphin, 4,4'-Bis-(dimethylamino)-benzophenon und einem halogenierten Kohlenwasserstoff (vgl. DE–A–27 59 164) oder den Acylphosphinoxid-Verbindungen und tertiären Aminen wie Methyldiethanolamin, Dimethylethanolamin oder Triethanolamid (vgl. DE–A–29 09 992) verwendet werden. Für solche Initiatorsysteme liegt die Gesamtkonzentration (Photoinitiator + Aktivator) bei 0,05 bis 8 Gew.-%, vorzugsweise 0,5 bis 5 Gew.-%, bezogen auf die photopolymerisierbare Schicht B.

Neben dem polymeren Bindemittel (Komponente B1), den photopolymerisierbaren, ethylenisch ungesättigten niedermolekularen Verbindungen (Komponente B2) sowie den Photopolymerisationsinitiatoren (Komponente B3) können in der photopolymerisierbaren Schicht B der erfindungsgemäßen Aufzeichnungsmaterialien als zusätzliche Komponente (B4) gebebenenfalls noch die üblichen Zusatzstoffe in üblichen Mengen enthalten sein. Hierzu gehören insbesondere thermische Polymerisationsinhibitoren, anorganische oder organische Pigmente oder Farbstoffe, anorganische oder organische Füllstoffe, Weichmacher, Mattierungs- oder Gleitmittel, etc.

Geeignete Polymerisations insbesonder sind die üblichen zur Verhinderung einer thermischen Polymerisation verwendeten Verbindungen, beispielsweise Hydrochinon, p-Methoxyphenol, p-Chinon, Kupfer-I-chlorid, Methylenblau, b-Naphthol, Phenole, m-Dinitrobenzol, N-Nitrosoamine wie N-Nitrosodiphenylamin, Phenothiazine, Phosphorigsäureester wie Triphenylphosphit, oder die Salze, beispielsweise die Kalium- oder Aluminium-Salze des N-Nitroso-cyclohexyl-hydroxylamins. Voraussetzung für die Auswahl derartiger Inhibitoren ist das Fehlen einer nennenswerten Eigenabsorption in dem aktinischen Bereich, in dem der gleichzeitig verwendete Photoinitiator absorbiert. Die Polymerisationsinhibitoren werden im allgemeinen in Mengen von 0,001 bis 2,0 Gew.-%, vorzugsweise in Mengen von 0,005 bis 0,5 Gew.-%, bezogen auf die Summe aller Komponenten der photopolymerisierbaren Schicht B, eingesetzt. Zur Steuerung der Belichtungseigenschaften der erfindungsgemäßen Aufzeichnungsmaterialien können in der photopolymerisierbaren Schicht B ferner Farbstoffe oder photochrome Zusätze enthalten sein. Der Zusatz von Farbstoffen oder Pigmenten kann auch der Identifizierung oder ästhetischen Zwecken dienen, vorausgesetzt, da die Farbstoffe die aktinische Strahlung nicht stark absorbieren und die Photopolymerisationsreaktion nicht stören.

Die photopolymerisierbare Schicht B kann darüberhinaus gegebenenfalls auch noch weitere Zusätze, wie z. B. verträgliche Weichmacher, Wachse, gesättigte niedermolekulare Verbindungen mit Amidgruppen etc., enthalten, mit deren Hilfe bestimmte, vom jeweiligen Anwendungsgebiet abhängige, spezielle Eigenschaften eingestellt und verbessert werden können. Beispielsweise ergibt ein Zusatz von Weichmachern in der photopolymerisierbaren Schicht B in bestimmten Mengen weichelastische Schichten mit gutem Rückstellverhalten, so daß sich der Zusatz von Weichmachern insbesondere bei photopolymerisierbaren Aufzeichnungsmaterialien empfiehlt, die beispielsweise für die Herstellung von weichelastischen Reliefdruck-Platten eingesetzt werden sollen. Durch Zusatz von andren Stoffen, wie z. B. bestimmten Polymeren oder Füllstoffen, kann entsprechend die Härte der belichteten Schichten erhöht werden. Als Weichmacher kommen die hierfür bekannten Verbindungen in Betracht, wie beispielsweise Phthalsäureester, Paraffinöle oder flüssige Polybutadien-Verbindungen. Weichmacher können in der photopolymerisierbaren Schicht B im allgemeinen in Mengen von 5 bis 30 Gew.-%, bezogen auf die Summe aller Komponenten der photopolymerisierbaren Schicht B, enthalten sein.

Die Beständigkeit der photopolymerisierbaren Aufzeichnungsmaterialien gegenüber Sauerstoff und Ozon kann - falls notwendig - verbessert werden, indem der photopolymerisierbaren Schicht B verträgliche bekannte Antioxidantien und/oder Ozonschutzmittel in geeigneter Menge zugesetzt werden.

Als Schichtträger A für die erfindungsgemäßen photopolymerisierbaren Aufzeichnungsmaterialien eignen sich die an sich bekannten und üblichen Trägermaterialien mit hinreichend hoher Dimensionsstabilität. Hierzu gehören Metallplatten oder -folien, beispielsweise aus Stahlblech, Aluminiumblech, Kupfer oder dgl., sowie Folien aus Hochpolymeren, wie z. B. Folien aus Polyethylenterephthalat, Polybutylenterephthalat, Polyamid oder Polycarbonat. Die Auswahl der Schichtträger A ist dabei nicht auf Platten oder Folien begrenzt, ebenso können Gewebe oder Vliese, wie Glasfasergewebe, als Trägermaterialien dienen. Die Auswahl des geeigneten Trägermaterials für den Schichtträger A hängt insbesondere von dem Anwendungszweck des photopolymerisierbaren Aufzeichnungsmaterials ab werden für die Herstellung beispielsweise von Photoresists vorzugsweise solchen Trägermaterialien verwendet, die insbesondere leicht ätzbar oder galvanisierbar sind. Für die Herstellung von weichelastomeren Reliefdruck-Platten werden als Schichtträger flexible Materialien mit ausreichend hohem Elastizitätsmodul herangezogen. Neben der direkten Verankerung der photopolymerisierbaren Schicht B auf einem Schichtträger A hoher Festigkeit und Dimensionsstabilität können zur Erzielung höherer Plattendicken, wie sie beim Flexodruck in der Praxis durch die Benutzung konventioneller Gummiklischees vorgegeben sind, als Unterschicht für die photopolymerisierbare Schicht B andere weichelastische Trägermaterialien eingesetzt werden, die ihrerseits mit einem dimensionsstabilen Schichtträger haftfest verbunden sind. Beispielsweise können für Mehrschichtverbundplatten weichelastische Unterschichten eingesetzt werden, wie sie in der DE–A– 24 44 118 beschrieben sind.

Die Herstellung der erfindungsgemäßen photopolymerisierbaren Aufzeichnungsmaterialien erfolgt in an sich bekannter Weise durch Herstellen und Verbinden der einzelnen Schichten. Zur Herstellung der photopolymerisierbaren Schicht B werden die einzelnen Komponenten (B1), (B2), (B3) sowie gegebenenfalls (B4) nach bekannten Verfahren homogen miteinander vermischt und zu Schichten gewünschter Schichtdicke verarbeitet. Die homogenen, im wesentlichen nicht lichtstreuenden Gemische aus den einzelnen Komponenten der Schicht B können nach üblichen Knet-, Misch- und Lösungsverfahren hergestellt werden. Die photopolymerisierbaren Schichten B können dann beispielsweise aus Lösungen der Gemische in geeigneten Lösungsmitteln (beispielsweise Tetrahydrofuran) durch Gießen auf die entsprechenden Schichtträger erzeugt werden. Ebenso können die photopolymerisierbaren Schichten B durch Pressen, Kalandrieren oder Extrudieren der Gemische hergestellt werden, wobei bei geeigneter Wahl der Inhibitoren keine thermische Anpolymerisation zu befürchten ist.

Die Gemische der Komponenten der Schicht B sowie die daraus hergestellten photopolymerisierbaren Schichten zeichnen sich aufgrund der erfindungsgemäß einzusetzenden Polyurethane (Komponente B1) durch eine leichte Handhabbarkeit und sehr gute Verarbeitbarkeit aus.

Zur Herstellung der photopolymerisierbaren Aufzeichnungsmaterialien können entweder vorgefertigte photopolymerisierbare Schichten B auf den Schichtträger A auflaminiert oder aufgepreßt werden, oder es kann, wie erwähnt, ein Gemisch der Komponenten, die die photopolymerisierbare Schicht B bilden, in geeigneter Weise, beispielsweise durch Gießen aus einer Lösung, auf den Schichtträger A aufgebracht und hier zu der photopolymerisierbaren Schicht B mit der gewünschten Schichtstärke geformt werden. Die letztgenannte Arbeitsweise ist bei den erfindungsgemäßen Massen wegen deren ausgezeichnetem Gelierverhalten von besonderem Vorteil.

In Abhängigkeit von den eingesetzten Materialien kann es dabei zweckmäßig und notwendig sein, die photopolymerisierbare Schicht B auf dem Schichtträger A mittels einer Haftschicht fest zu verankern. Diese Haftschicht kann als Zwischenlack in einer Schichtdicke von etwa 0,5 bis 40 µm verwendet werden. Als Haftschichten können handelsübliche Ein- oder Zweikomponetenkleber verwendet werden, deren Art sich nach dem Schichtträgermaterial und nach den aufgebrachten Materialien der photopolymerisierbaren Schicht B richtet. Als häufig geeignete Kleber seien die handelsüblichen Reaktionskleber auf Polyurethan- und auf Polychloropren-Basis genannt, die durch Substrieren oder Gießen in geeigneter Schichtdicke auf die zu verbindenden Schichten aufgebracht werden können.

Es ist oft von Vorteil, wenn bei den photopolymerisierbaren Aufzeichnungsmaterialien auf der dem Schichtträger abgewandten Oberfläche der photopolymerisierbaren Schicht B noch eine haftfest verbundene, dünne, klebfreie Deckschicht C aufgebracht ist. Eine solche haftfest verbundene Deckschicht C besteht bevorzugt aus einem harte, klebfreie, transparente und reifeste Filme bildenden Polymeren. Da die Belichtung des photopolymerisierbaren Aufzeichnungsmaterials in diesen Fällen durch die Deckschicht C hindurch erfolgt und die Schicht C erst beim anschließenden Entwickeln durch Abwaschen mit dem Entwickler-Lösungsmittel entfernt wird, soll die Deckschicht C aus solchen Polymeren bestehen, die im Entwickler-Lösungsmittel löslich sind. Die Stärke der Deckschicht C soll je nach Anwendungsbereich der Aufzeichnungsmaterialien im

allgemeinen zwischen etwa 0,1 bis 20 µm, zweckmäßigerweise zwischen etwa 0,5 bis 5 µm liegen. Als Beispiele für Polymere, die für die Herstellung der Deckschicht C in Betracht kommen, seien genannt: lösliche Polyamide und Copolyamide, Polyurethane, Polyvinylalkohol oder dessen Partialester, -ether oder -acetale, Gelatine, Polyvinylpyrrolidone, Polyethylenoxide mit Molekulargewichten über 100 000 und andere. Durch die haftfest verbundene Deckschicht C ist z. B. eine klebfreie, blasenfreie Negativauflage bei der Belichtung möglich; ferner wird der Zutritt von die Photopolymerisation inhibierendem Sauerstoff zu der photo-polymerisierbaren Schicht B verhindert.

Es ist ferner oft vorteilhaft, die photopolymerisierbaren Aufzeichnungsmaterialien mit einer abziehbaren Deckfolie zu versehen, wobei diese direkt auf die photopolymerisierbare Schicht B aufgebracht sein oder zusammen mit der oben erwähnten haftfest verbundenen Deckschicht C verwendet werden kann. Die Deckfolie, die beispielsweise aus Polyamid oder einem Polyester, wie Polyethylenterephthalat oder Polybutylenterephthalat bestehen kann, und die vorteilhafterweise eine Schichtstärke im Bereich von etwa 20 bis 150 µm besitzt, wird im allgemeinen vor der bildmäßigen Belichtung der Aufzeichnungsmaterialien abgezogen; bei hinreichender Transparenz der Deckschicht kann die Belichtung jedoch auch durch diese hindurch erfolgen, wobei die Deckschicht dann vor der Entwicklung abgezogen wird.

Die photopolymerisierbaren Aufzeichnungsmaterialien zeichnen sich aufgrund der erfindungsgemäß einzusetzenden speziellen Polyurethan-Bindemittel (Komponente B1) neben der leichten Verarbeitbarkeit durch eine gute Handhabbarkeit aus. Sie sind vergleichsweise thermostabil und auch über längere Zeiträume gut lagerfähig, ohne daß nachteilige Veränderungen, wie z. B. durch Alterung, Versprödung oder Kaltfluß, in Kauf genommen werden müssen. Die photopolymerisierbaren Aufzeichnungsmaterialien der Erfindung besitzen sehr gute Belichtungseigenschaften, d.h. sie sind leicht und schnell vernetzbar, obwohl sie im Vergleich zu anderen Materialien dieser Art einen geringeren Anteil an photopolymerisierbaren Monomeren oder Oligomeren (Komponente B2) enthalten, und sie besitzen einen positiven Belichtungsspielraum. Wegen der guten mechanischen Eigenschaften der in der Komponente (B1) erfindungsgemäß einzusetzenden Polyurethane lassen sich mit den erfindungsgemäßen photopolymerisierbaren Aufzeichnungsmaterialien leicht Druckplatten mit dem jeweils gewünschten Eigenschaftsniveau herstellen, ohne daß hierbei andere Nachteile in Kauf genommen werden müssen. So lassen sich beispielsweise leicht photopolymerisierbare Aufzeichnungsmaterialien herstellen, deren Schicht B nach der Belichtung eine Shore A-Härte (DIN 53 505) von 50 bis 95 besitzt, wie es beispielsweise für die Herstellung von weichelastomeren Reliefdruckplatten erstrebenswert ist.

Die photopolymerisierbaren Aufzeichnungsmaterialien der Erfindung eignen sich insbesondere zur photochemischen Informationsfixierung durch bildmäßiges Belichten der photopolymerisierbaren Schicht B und anschließendes Entfernen der unbelichteten, unvernetzten Schichtanteile, insbesondere durch Auswaschen mit einem Entwicklerlösungsmittel in an sich bekannter Weise. Die Schichtstärke der photopolymerisierbaren Schicht B und der spezielle Aufbau der photopolymerisierbaren Aufzeichnungsmaterialien richten sich dabei nach dem speziellen Anwendungszweck. Während die Schichtstärke der photopolymerisierbaren Schicht B im allgemeinen leicht zwischen 0,005 und 6,5 mm Dicke variiert werden kann, werden beispielsweise bei der Herstellung von Photoresists Schichtdicken von 5 bis 70 µm verwendet. Für die Herstellung von Reliefdruckplatten beträgt die Schichtstärke der photopolymerisierbaren Schicht B im allgemeinen von einigen 100 µm bis zu einigen mm Dicke. Zur Herstellung von Druckplatten mit reliefbildenden Schichten von 3,0 mm bis 6,5 mm kann beispielsweise die photopolymerisierbare Schicht B auch aus Einzelschichten von photopolymerisierbaren Gemischen gegebenenfalls unter Verwendung von anlösenden Lösungsmitteln zusammenlaminiert werden. Dabei können zur Erzielung besonderer Druckeigenschaften Schichten unterschiedlicher Härte und Rezeptur verwendet werden. Zur Herstellung von Reliefplatten für den Flexodruckbereich können auch Aufzeichnungsmaterialien mit einem Mehrschichtenverbund entsprechend der DE–A–24 44 118 vorteilhaft sein, die eine elastomere, weichelastische Unterschicht sowie eine weitere Stabilisierungsschicht besitzen.

Die Belichtung der photopolymerisierbaren Aufzeichnungsmaterialien kann in Form einer Flach- oder Rundbelichtung erfolgen. Als Strahlungsquellen für das die Photopolymerisation bzw. Photovernetzung auslösende Licht können die handelsüblichen Lichtquellen von aktinischem Licht verwendet werden, wie beispielsweise UV-Fluoreszenzröhren, Quecksilbermitteldruckstrahler, aber auch Quecksilberhoch- oder -niederdruckstrahler, sowie superaktinische Leuchtstoffröhren, Xenon-Impulslampen, Metalliodid-dotierte Lampen, Kohlebogenlampen etc. Die Strahlungsquellen sollen ein Licht einer Wellenlänge zwischen 230 und 450 nm aussenden. Die emittierte Wellenlänge sollte bevorzugt bei 300 bis 420 nm liegen bzw. auf die Eigenabsorption des in der photopolymerisierbaren Schicht B enthaltenen Photoinitiators abgestimmt sein.

Als Entwickler-Lösungsmittel für das Auswaschen der unbelichteten, unvernetzten Anteile der Schicht B nach der bildmäßigen Belichtung kommen bei den erfindungsgemäßen Aufzeichnungsmaterialien Alkohol oder Alkohol Wasser-Gemische in Betracht. Beispiele für Alkohole sind Methanol, Ethanol oder Isopropanol. Die Alkohol-Wasser-Gemische können z.B. Ethanol/Wasser im Gewichtsverhältnis 8:2 enthalten.

Nach dem Auswaschen mit dem Entwicklungs-Lösungsmittel werden die resultierenden Reliefformen, z.B. Reliefdruckformen oder Photoresists, in üblicher Weise, gegebenenfalls bei Temperaturen bis zu 120°C, getrocknet. In manchen Fällen ist es zweckmäßig, die erhaltenen Reliefformen anschließend nochmals mit aktinischem Licht nachzubelichten, um die Festigkeit der Formen bzw. Druckplatten zu erhöhen. Die gemäß der Erfindung hergestellten Druckformen können für alle Arten von Druckverfahren verwendet werden. Besonders vorteilhaft lassen sich mit den erfindungsgemäßen Aufzeichnungsmaterialien weichelastomere Druckformen herstellen, die für Anwendungsbereiche geeignet sind, bei denen eine elastische, nachgiebig druckende Fläche erforderlich ist. In diesen Fällen soll daher die photopolymere, reliefbildende Schicht B nach der Belichtung

eine Shore A-Härte (DIN 53 505) von 50 bis 95, vorzugsweise von 60 bis 90, besitzen. Die Reliefdruckformen eignen sich dabei insbesondere für den Druck mit Ifarben.

Zur Herstellung von Photoresists mittels der erfindungsgemäßen photopolymerisierbaren Aufzeichnungsmaterialien kann auch das Schichtübertragungsverfahren, wie es beispielsweise in der DE-B- 15 22 515 und der DE-B- 21 23 702 beschrieben wird, angewandt werden. Die Photoresists eignen sich in bekannter Weise zur galvanischen oder stromlosen Metallablagerung, zum tzen und für die Gravur, z.B. bei der Herstellung von gedruckten Schaltungen, integrierten Schaltkreisen, Siebdruckschablonen und anderem.

Die folgenden Beispiele sollen die vorliegende Erfindung weiter erläutern. Die in den Beispielen genannten Teile und Prozesse beziehen sich, soweit nicht anders angegeben, auf das Gewicht. Volumenteile verhalten sich zu Teilen wie Liter zu Kilogramm. Die angegebenen Viskositäten wurden unter den jeweils angegebenen Versuchsbedingungenbestimmt.

Die angegebenen K-Werte wurden 1%ig in Dimethylformamid gemessen. Die Shore A-Härte wurde ermittelt nach DIN 53 505. Die Reißdehnung und Reißkraft wurden nach DIN 53 504 ermittelt. Synthesebeispiele zur Herstellung von erfindungsgemäß als Komponente (B1) einzusetzenden Polyurethanen:

**Synthesebeispiel I**

400 g Polyethylenoxyd (MG 1000), 32,15 g einer 70%igen acetonischen Lösung des Diacrylats von Bisphenol-A-diglycidylether und 31,5 g Butandiol-1,4 werden in 600 g Tetrahydrofuran bei Raumtemperatur vorgelegt. Nach Zugabe von 1,1 g Dibutylzinndilaurat werden 148,7 g Hexamethylendiisocyanat zugetropft, wobei die Temperatur in der Reaktionsmischung auf ca. 60°C ansteigt. Nach 90 Minuten wird die Reaktionsmischung mit 415 g Tetrahydrofuran verdünnt und nach weiteren 15 Minuten werden durch Zugabe von 40 g Methanol noch eventuell vorhandene NCO-Gruppen desaktiviert. Das so erhaltene Polyurethan hat einen K-Wert von 56. Die Reißfestigkeit $\sigma_R$ beträgt 11 N/mm$^2$, die Reißdehnung $\varepsilon_D$ 860%, bei einer Shore A-Härte von 80.

**Synthesebeispiel II**

In 660 g Tetrahydrofuran werden 400 g Polyethylenoxid mit MG 1000, 128 g einer 70%igen acetonischen Lösung des Diacrylats von Bisphenol A-diglycidylether und 31,5 g Butandiol-1,4 unter Rühren bei Raumtemperatur gelöst. Nach Zugabe von 1,8 g Dibutylzinndilaurat werden 176 g Hexamethylendiisocyanat zugegeben, wobei die Temperatur auf 60°C ansteigt. Nach 90 Minuten wird die Reaktionsmischung mit 540 g Tetrahydrofuran verdünnt. Nach weiteren 15 Minuten werden durch Zugabe von 60 g Methanol noch eventuell vorhandene Isocyanatgruppen desaktiviert. Das auf diese Weise erhaltene Polyurethan weist einen K-Wert von 44 auf. Die Reißfestigkeit $\sigma_R$ liegt bei 13,5 N/mm$^2$, die Reißdehnung $\varepsilon_D$ bei 900% bei einer Shore-A-Härte von 79.

**Beispiel 1**

78,5 Teilen eines gemäß Synthesebeispiel I hergestellten Polyurethans werden zusammen mit 20 Teilen eines präpolymeren Urethandiacrylats (Zusammensetzung: 1 ÄG eines Polyesterdiöls, 2 ÄG Isophorondiisocyanat, 1,3 ÄG Butandiolmonoacrylat), 1,5 Teilen Benzildimethylketal, 0,02 Teilen Zaponechtschwarz RE (C.I. 12195, Solvent Black 34), 0,25 Teilen des Kaliumsalzes des N-Nitrosocyclohexyl-hydroxylamin und 0,025 Teilen des sek. Butylthioanthrachinons in Tetrahydrofuran bei 50°C unter Rühren zu einer ca. 50 %igen Lösung gelöst und in solcher Schichtstärke auf eine Polyesterfolie aufgegossen, daß nach einstündigem Trocknen bei 60°C eine Schicht mit 0,7 mm Dicke zurückbleibt. Die Polyesterfolie war zuvor mit einer ca. 2 µm dicken Schicht aus Polyamid beschichtet worden. Mit Hilfe dieser Beschichtung läßt sich die photopolymerisierbare Schicht wieder von der Polyesterfolie abheben, wobei die Polyamid-Schicht auf der photopolymerisierbaren Reliefschicht verbleibt. Zur Verankerung auf einer Trägerschicht wird eine Metallträgerplatte mit einem handelsüblichen Polyurethanlack beschichtet und auf die freie Seite der photopolymerisierbaren Reliefschicht aufgewalzt.

Nach Abheben der Polyesterfolie (Deckfolie) wird ein photographisches Negativ aufgelegt und 4 Minuten in einem handelsüblichen Flachbelichter (40 Watt-UV-Fluoreszenzlampen) unter einer Vakuumfolie bildmäßig belichtet. Anschließend wird die belichtete Platte in einem Sprühwascher mit einem Ethanol/Wasser-Gemisch (9:1-Vol.Teile) ca. 5 Minuten ausgewaschen, wobei die unbelichteten Schichtanteile herausgelöst werden. Die erhaltene Reliefform wird anschließend 30 Minuten bei 60°C getrocknet und in dem gleichen Belichter ohne Abdeckung nachbelichtet. Die Reliefform, deren Reliefschicht eine Shore A-Härte von 80, eine Reißdehnung von 158 % und eine Reißfestigkeit von 10,8 N/mm$^2$ besitzt, eignet sich ausgezeichnet als Druckplatte für Druckfarben aus Mineralölbasis. Die Drucke zeigen eine exakte Wiedergabe der Vorlage mit randscharfen Details. Die Elastizität der Druckform ist sehr gut.

**Beispiel 2**

Eine Reliefdruckform mit einer Reliefschichtdicke von 0,5 mm für ölfeste Flexodruckzwecke wird wie folgt hergestellt:

Auf eine 0,125 mm dicke Polyester-Trägerfolie, die mit einem in einer wäßrigen Alkohol-Lösung löslichen Polyamid (ca. 2 µm) beschichtet ist, wird eine ca. 45%ige Lösung (Lösungsmittel: Tetrahydrofuran) von 78,5 Teilen eines gemäß Synthesebeispiel II hergestellten Polyurethans, 20 Teilen eines präpolymeren Urethanacrylats (Zusammensetzung: 1 G eines Polyesterdiols, 2 G Isophorondiisocyanat, 1,3 G Butandiolmonoacrylat), 1,5 Teile Benzildimethylketal, 0,03 Teilen eines schwarzen Farbstoffes (C.I. 26150, Solvent Black 3), aufgerakelt und anschließend 60 Minuten bei 60°C getrocknet. Die so erhaltene photopolymerisierbare Reliefschicht wird auf einer mit einem handelsüblichen Zweikomponenten-Polyurethanhaftkleber beschichteten Polyesterfolie aufgewalzt. Die unbelichtete Folienplatte wird von der Plattenrückseite her, d.h. durch die Trägerfolie hindurch, in dem in Beispiel 1 eingesetzten Flachbelichter 1 Sekunde vorbelichtet. Anschließend wird die Polyester-Deckfolie von der Plattenoberseite abgezogen, ein fotographisches Negativ aufgelegt und die Platte 6 Minuten in dem Flachbelichter von Beispiel 1 belichtet. Nach 5-minütigem Auswaschen in einem handelsüblichen Bürstenwascher mit einem Entwicklerlösungsmittelgemisch aus Ethanol/Wasser (9:1) Vol.-Teile) und einstündigem Trocken bei 60°C wird 10 Minuten nachbelichtet. Die Relief-Schicht besitzt hiernach eine Shore A-Härte von 84, eine Reißfestigkeit von 6,3 $N/mm^2$ und eine Reißdehnung von etwa 56%. Die erhaltene Reliefdruckplatte weist ein hohes Auflösevermögen und hohe Auflagenbeständigkeit auf.

**Patentansprüche**

1. Photopolymerisierbares Aufzeichnungsmaterial mit einem Schichtträger A, einer damit direkt oder indirekt haftfest verbundenen, in alkoholischer Lösung löslichen oder zumindest dispergierbaren photopolymerisierbaren Schicht B sowie gegebenenfalls einer Deckschicht und/oder Deckfolie C, bei dem die photopolymerisierbare Schicht B enthält

1. als polymeres Bindemittel ein in einem Lösungsmittel lösliches Polyurethan aus einem Diisocyanat, einem Polyetherdiol und einer weiteren difunktionellen Verbindung mit seitenständigen photopolymerisierbaren Doppelbindungen,
2. mindestens eine photopolymerisierbare, ethylenisch ungesättigte niedermolekulare Verbindung,
3. einer Photopolymerisationsinitiator sowie
4. gegebenenfalls sonstige übliche Zusatzstoffe,

dadurch gekennzeichnet, daß in der photopolymerisierbaren Schicht B als Bindemittel (Komponente B1) ein lineares, bei Raumtemperatur festes, hochmolekulares, thermoplastisches Polyurethan enthalten ist, das keine quaternären und/oder quaternisierbaren Stickstoffatome eingebaut enthält und erhalten worden ist durch Umsetzung einer Reaktionsmischung von

a) 10 bis 40 Gew.% eines Diisocyanats
b) 30 bis 85 Gew.% eines Polydiols bestehend zu 50 bis 100 Gew.%, bezogen auf die Polydiol-Komponente b), aus mindestens einem Polyetherdiol mit einem Molekulargewicht von 250 bis 4000 aus der Gruppe der Polyethylenglykole,Polypropylen
glykole und Ethylenglykol-/Propylenglykol-Mischpolykondensationsprodukte sowie 0 bis 50 Gew.%, bezogen auf die Polydiol-Komponente b), mindestens eines weiteren verträglichen Polydiols,
c) 0,1 bis 20 Gew.% einer kettenverlängernden, im Sinne der Isocyanatchemie bifunktionell reaktionsfähigen Verbindung mit seitenständigen aktivierten photopolymerisierbaren Doppelbindungen sowie
d) 0 bis 20 Gew.% eines weiteren niedermolekularen Kettenverlängerers,

wobei die angegebenen Gew.% für die Komponenten der Reaktionsmischung jeweils auf die Summe der Komponenten a) bis d) bezogen sind und das NCO/OH, NH-Molverhältnis in der Reaktionsmischung 0,8 bis 1,3 beträgt.

2. Photopolymerisierbares Aufzeichnungsmaterial gemäß Anspruch 1, dadurch gekennzeichnet, daß das Polyurethan der Komponente (B1) einen K-Wert im Bereich von etwa 25 bis 75, insbesondere von etwa 35 bis 65, besitzt

3. Photopolymerisierbares Aufzeichnungsmaterial gemäß Ansprüchen 1 bis 2, dadurch gekennzeichnet, daß das in der Komponente (B1) einzusetzende Polyurethan einen Gehalt an seitenständigen photopolymerisierbaren Doppelbindungen von 0,01 bis 2,5 Gew-.-%, insbesondere von 0,05 bis 2 Gew.-%, bezogen auf das Gewicht des Polyurethans, aufweist.

4. Photopolymerisierbares Aufzeichnungsmaterial gemäß Ansprüchen 1 bis 3, dadurch gekennzeichnet, daß das in der Komponente (B1) einzusetzende Polyurethan seitenständige Acryloyl- und/oder Methacryloyl-Gruppen eingebaut enthält.

5. Photopolymerisierbares Aufzeichnungsmaterial gemäß Ansprüchen 1 bis 4, dadurch gekennzeichnet, daß die photopolymerisierbare Schicht B

1. 50 bis 95 Gew.%, bezogen auf die Komponenten B1 und B2, des polymeren Bindemittels
2. 50 bis 5 Gew.%, bezogen auf die Komponenten B1 und B2, der photopolymerisierbaren, niedermolekularen ethylenisch ungesättigten Verbindung,
3. 0,02 bis 5 Gew.%, bezogen auf die gesamte Schicht B, des Photopolymerisationsinitiators sowie
4. 0 bis 30 Gew.%, bezogen auf die gesamte Schicht B, an Zusatzstoffen enthält.

6. Verfahren zur Herstellung von Reliefformen durch bildmäßiges Belichten einer photopolpmerisierbaren Schicht eines Aufzeichnungsmaterials mit aktinischem Licht, Auswaschen der unbelichteten, unvernetzten Bereiche der photopolymerisierbaren Schicht mit einem alkoholischen Entwicklerlösungsmittel und anschließendes Trocknen sowie gegebenenfalls Nachbelichten der erhaltenen Reliefform, dadurch gekennzeichnet, daß ein photopolymerisierbares Aufzeichnungsmaterial gemäß einem der Ansprüche 1 bis 5 verwendet wird.

**Revendications**

1. Matière d'enregistrement photopolymérisable comportant une couche support A, une couche photopolymérisable B, soluble ou au moins dispersable en solution alcoolique, liée directement ou indirectement, avec forte adhérence, à la couche A, ainsi qu'éventuellement une couche de recouvrement et/ou feuille de recouvrement C, la couche photopolymérisable B contenant
1. comme liant polymère, un polyuréthane soluble dans un solvant et obtenu à partir d'un diisocyanate, d'un polyétherdiol et d'un autre composé difonctionnel à doubles liaisons photopolymerisables latérales,
2. au moins un composé à faible poids moléculaire, à insaturation éthylénique, photopolymérisable,
3. un initiateur de photopolymérisation ainsi que
4. éventuellement d'autres additifs usuels,

caractérisée par le fait que, dans la couche photopolymérisable B, est contenu, comme liant (composant B1), un polyuréthane thermoplastique, à poids moléculaire élevé, solide à température ambiante, linéaire, qui ne contient incorporé aucun atome d'azote quaternaire et/ou quaternisable et qui a été obtenu par réaction d'un mélange de réaction de
a) 10 à 40 % en poids d'un diisocyanate
b) 30 à 85 % en poids d'un polydiol constitué, à raison de 50 à 100 % en poids, rapporté à la composante polydiol b), d'au moins un polyétherdiol d'un poids moléculaire de 250 à 4000, appartenant au groupe des polyéthylèneglycols, polypropylèneglycols et produits de copolycondensation d'éthylèneglycol-/propylèneglycol, ainsi que 0 à 50 % en poids, rapporté au composant polydiol b), d'au moins un autre polydiol compatible,
c) 0,1 à 20 % en poids d'un composé réactif bifonctionnel, au sens de la chimie de l'isocyanate, allongeur de chane, et à doubles liaisons photopolymérisables, activées, latérales, ainsi que
d) 0 à 20 % en poids d'un autre allongeur de chane, à faible poids moléculaire,

les pourcentages en poids indiqués pour les composante du mélange de réaction étant rapportés chacun à la somme des composante a) à d) et le rapport molaire NCO/OH,NH dans le mélange de réaction étant de 0,8 à 1,3.

2. Matière d'enregistrement photopolymérisable selon la revendication 1, caractérisée par le foit que le polyuréethane du composant (B1) possède un indice K situé sans les limites d'environ 25 à 75, en particulier d'environ 35 à 65.

3. Matière d'enregistrement photopolymérisable selon les revendication 1 à 2, caractérisé par le fait que le polyuréthene à introduire dans le composant (B1) possède une taneur en doubles liaisons photopolymérisables letérales de 0,01 à 2,5 % en poids, en particulier de 0,05 à 2 % en poids, rapportés au poids du polyuréthane.

4. Matière d'enregistrement photopolymérisable selon les revendications 1 à 3, caractérisée par le fait que le polyuréthane à introduire dans le composant (B1) contient dans sa structure des groupes acryloyle et/ou méthacryloyle latéraux.

5. Matière d'enregiestrement photopolymérisable selon les revendications 1 à 4, caractérisée par le fait que la couche photopolymérisable B contient :
1. 50 à 95 % en poids, rapporté aux composants B1 et B2, du liant polymère,
2. 50 à 5 % en poids, rapporté aux composants B1 et B2, du composé insaturé éthyleniquement, de faible poids moléculaire et photopolymérisable,
3. 0,02 à 5 % en poids, rapporté à l'ensemble de la couche B, de l'initiateur de polymérisation, ainsi que,
4. 0 à 30 % en poids, rapporté à l'ensemble de la couche B, d'additifs.

6. Procédé de préparation de formes en relief par exposition, suivant une figure, d'une couche photopolymérisable d'une matière d'enregistrement, à de la lumière actinique, enlevage des zones non réticulées, non exposées de la couche photopolymérisable avec un solvant de développement alcoolique et

enfin séchage ainsi qu'éventuellement exposition supplémentaire de la forme en relief obtenue, caractérisé par le fait qu'on utilise une matière d'enregistrement photopolymérisable selon l'une des revendications 1 à 5.

**Claims**

1. A photopolymerizable recording material comprising a base A and a photopolymerizable layer B which is directly or indirectly bonded thereto and is soluble or at least dispersible in an alcoholic solution, with or without a top layer and/or cover sheet C, the photopolymerizable layer B comprising

1. as polymeric binder, a polyurethane which is soluble in a solvent and has been prepared from a diisocyanate, a polyether-diol and a further difunctional compound possessing photopolymerizable double bonds in side branches,
2. at least one photopolymerizable, ethylenically unsaturated, low molecular weight compound, and
3. a photopolymerization initiator, with or without
4. other conventional additives,

wherein the photopolymerizable layer B contains, as the binder (component B1), a linear, high molecular weight, thermoplastic polyurethane which is solid at room temperature, does not possess any quaternary and/or quaternizable nitrogen atoms, and has been obtained by reacting a mixture of

a) from 10 to 40 % by weight of a diisocyanate,
b) from 30 to 85 % by weight of a polydiol comprising from 50 to 100 % by weight, based on the polydiol component b), of at least one polyether-diol having a molecular weight of from 250 to 4,000 and selected from the group consisting of the polyethylene glycols, polypropylene glycols and ethylene glycol/propylene glycol copolycondensates, and from 0 to 50 % by weight, based on the polydiol component b), of at least one further compatible polydiol,
c) from 0.1 to 20 % by weight of a chain-extending compound which is bifunctionally reactive towards isocyanates and possesses activated photopolymerizable double bonds in side branches, and
d) from 0 to 20 % by weight of another low molecular weight chain extender,

each of the above percentages of the components of the reaction mixture being based on the sum of the components a), b), c) and d), and the NCO/OH plus NH molar ratio provided by the reactants being from about 0.8 to 1.3.

2. A photopolymerizable recording material as claimed in claim 1, wherein the polyurethane constituting component (B1) has a K value of from about 25 to 75, particularly from about to 35 to 65.

3. A photopolymerizable recording material as claimed in claims 1 and 2, wherein the polyurethane to be used as component (B1) contains from 0.01 to 2.5 % by weight, based on the weight of polyurethane, of photopolymerizable double bonds in side branches.

4. A photopolymerizable recording material as claimed in claims 1 to 3, wherein the polyurethane to be used as component (B1) contains acryloyl and/or methacryloyl groups in side branches.

5. A photopolymerizable recording material as claimed in claims 1 to 4, wherein the photopolymerizable layer B contains

1. from 50 to 95 % by weight, based on components B1 and B2, of the polymeric binder,
2. from 50 to 5% by weight, based on components B1 and B2, of the photopolymerizable, ethylenically unsaturated, low molecular weight compound,
3. from 0.02 to 5% by weight, based on the total layer B, of the photopolymerization initiator, and
4. from 0 to 30% by weight, based on the total layer B, of additives.

6. A process for the production of relief plates by imagewise exposure of a photopolymerizable layer of a recording material to actinic light, washing out the unexposed, non-crosslinked areas of the photopolymerizable layer with an alcoholic developer, and subsequently drying the resulting relief plate, with or without after-exposure, wherein a photopolymerizable recording material as claimed in any of claims 1 to 5 is used.